# EUROPÄISCHE PATENTANMELDUNG

(11) **EP 4 661 290 A1**
(43) Veröffentlichungstag der Anmeldung: **10.12.2025**
(21) Anmeldenummer: 25172651.9
(22) Anmeldetag: 25.04.2025
(51) Int. Cl.: H03G 3/04, H03G 3/30, H03G 3/32, H03G 5/00, H03G 5/22

(54) **VORRICHTUNG ZUM ANPASSEN DER LAUTSTÄRKE EINES AUDIOSIGNALS IN EINEM AUDIOSYSTEM EINES KRAFTFAHRZEUGS**

(30) Priorität: 07.06.2024 DE 102024116022
(71) Anmelder: Bayerische Motoren Werke Aktiengesellschaft, 80809 München (DE)
(72) Erfinder: Stupiggia, Andrea, 82041 Deisenhofen (DE); Binder, Markus, 84032 Landshut (DE); Stickel, Andreas, 82541 Münsing (DE)

(57) **Zusammenfassung**

Es wird eine Vorrichtung zum Anpassen der Lautstärke eines Audiosignals in einem Audiosystem eines Kraftfahrzeugs vorgeschlagen, wobei das Audiosystem einen Eingang zum Empfangen des Audiosignals von einer Eingangsquelle und einen Ausgang zum Ausgeben des Audiosignals aufweist, wobei die Lautstärke des Audiosignals mittels eines Reglers des Audiosystems einstellbar ist, wobei die Vorrichtung eine Steuereinheit aufweist, die dazu ausgebildet ist, eine Audiosignalverstärkung basierend auf der aktuellen Lautstärke des Audiosignals und basierend auf einer aktuellen Geschwindigkeit des Kraftfahrzeugs zu bestimmen, einen ersten Lautstärkeinkrementfaktor basierend auf der eingestellten Lautstärke zu bestimmen, und die Lautstärke des Audiosignals unter Verwendung der Audiosignalverstärkung und des ersten Lautstärkeinkrementfaktors anzupassen. Die Steuereinheit ist des Weiteren dazu ausgebildet, eine Verstärkung von tiefen Frequenzen basierend auf der aktuellen Geschwindigkeit des Kraftfahrzeugs zu bestimmen, einen zweiten Lautstärkeinkrementfaktor basierend auf der eingestellten Lautstärke zu bestimmen, und die Lautstärke von tiefen Frequenzen des Audiosignals unter Verwendung der Verstärkung von tiefen Frequenzen und des zweiten Lautstärkeinkrementfaktors anzupassen, und/oder die Steuereinheit ist dazu ausgebildet ist, eine Ausgabe des Audiosignals über Körperschallwandler des Kraftfahrzeugs basierend auf der aktuellen Geschwindigkeit des Kraftfahrzeugs unter Verwendung eines Körperschallwandlerparameters anzupassen.

## Beschreibung

Die vorliegende Erfindung betrifft eine Vorrichtung zum Anpassen der Lautstärke eines Audiosignals in einem Audiosystem eines Kraftfahrzeugs gemäß Patentanspruch 1 sowie ein Kraftfahrzeug mit einer solchen Vorrichtung gemäß Patentanspruch 8. Des Weiteren betrifft die vorliegende Erfindung ein Verfahren zum Anpassen der Lautstärke eines Audiosignals in einem Audiosystem eines Kraftfahrzeugs gemäß Patentanspruch 9.

In heutigen Fahrzeugen wird häufig eine dynamische Fahrgeräuschkompensation (DFK) eingesetzt. Diese Funktion erhöht oder verringert die Laustärke des abgespielten Audiosignals aus einer Entertainmentaudioquelle im Fahrzeug (z.B. Radio) in Abhängigkeit von der Geschwindigkeit und in Abhängigkeit von dem eingestellten Lautstärke-Inkrement, d.h. der durch den Benutzer eingestellten Lautstärke. Hierbei wird das Audiosignal in seiner vollen Frequenzbandbreite, d.h. auch tiefe Frequenzen, wie Basstöne, in der ausgegebenen Lautstärke verändert.

Damit ist das Audiosignal gut im Fahrzeug zu hören, auch wenn aufgrund der Fahrtgeschwindigkeit Geräusche im Fahrzeug vorhanden sind. Allerdings erhöhen sich bei hohen Geschwindigkeiten die allgemeinen Geräusche und Vibrationen im Fahrzeug, so dass gerade tiefere Frequenzen, beispielsweise zwischen 100 und 500 Hz, nicht mehr so gut wahrgenommen werden können, da sie in den Vibrationen des Fahrzeugs untergehen. Zwar wird in bestehenden Systemen bereits eine separate Verstärkung der tiefen Frequenzen vorgenommen, allerdings werden die tiefen Frequenzen mit demselben Lautstärkeinkrementfaktor wie das restliche Audiosignal behandelt. Es hat sich jedoch herausgestellt, dass die Verarbeitung mit demselben Lautstärkeinkrementfaktor bei tiefen Frequenzen keine optimale Parametrisierung der Anhebung, unterschiedlich für tiefe und hohe Frequenzen, ermöglicht und das Klangerlebnis im Fahrzeug daher nicht optimal ist.

Ähnliches gilt für Körperschallwandler, sogenannte Shaker oder Bass-Shaker. Diese können in den Sitzen des Fahrzeugs eingebaut werden und wandeln tiefe Frequenzen (Bassfrequenzen) über die Fläche, an der sie montiert sind, in Körperschall um. Die Bass-Shaker übertragen also tiefe Töne direkt auf den Körper der Fahrzeuginsassen. Damit erzeugen sie ein Körpergefühl, um das Audiosignal, z.B. Musik zu unterstützen. Allerdings werden auch die tiefen Frequenzen der Körperschallwandler durch Vibrationen des Fahrzeugs, gerade bei höheren Geschwindigkeiten, nicht mehr gut wahrgenommen.

Der vorliegenden Erfindung liegt daher die Aufgabe zugrunde, eine Möglichkeit bereitzustellen, um die Ausgabe von tiefen Frequenzen, sowohl über Lautsprecher als auch über Körperschallwandler bei einer Veränderung der Geschwindigkeit eines Fahrzeugs optimiert anzupassen.

Diese Aufgabe wird durch eine Vorrichtung zum Anpassen der Lautstärke eines Audiosignals in einem Audiosystem eines Kraftfahrzeugs gemäß Patentanspruch 1, ein Kraftfahrzeug mit einer solchen Vorrichtung gemäß Patentanspruch 8 sowie ein Verfahren zum Anpassen der Lautstärke eines Audiosignals in einem Audiosystem eines Kraftfahrzeugs gemäß Patentanspruch 9 gelöst.

Die Vorrichtung dient zum Anpassen der Lautstärke eines Audiosignals in einem Audiosystem eines Kraftfahrzeugs. Das Audiosystem weist einen Eingang zum Empfangen eines Audiosignals von einer Eingangsquelle und einen Ausgang zum Ausgeben des Audiosignals auf. Das Audiosystem kann Musik oder andere Audiosignale (z.B. Navigationsansagen) von verschiedenen externen oder in dem Audiosystem integrierten Eingangsquellen, beispielsweise Entertainmentquellen, abspielen. Unter einer Entertainmentquelle kann in diesem Zusammenhang eine Audioquelle verstanden werden, über die Unterhaltung, wie beispielsweise Musik oder Hörbücher, aber auch Telefonate oder Ansagen eines Navigationsgeräts, in Form von Audiosignalen ausgegeben werden kann. Die interne Entertainmentquelle, beispielsweise eine fahrzeuginterne Entertainmentquelle, kann unter anderem ein Radio, ein in dem Audiosystem integrierter CD-Spieler, eine im Audiosystem integrierte Festplatte oder eine Speicherkarte sein, die beispielweise über einen USB-Anschluss verbunden ist ("USB -Stick"). Die externe Entertainmentquelle kann mit dem Audiosystem beispielsweise über Bluetooth oder einen AUX-Eingang verbunden werden. Bei der externen Entertainmentquelle kann es sich beispielsweise um ein Smartphone oder einen MP3-Player handeln.

Die Audiosignale der externen Entertainmentquellen und der internen Entertainmentquellen werden über das Lautsprechersystem des Audiosystems ausgegeben. Die Lautstärke des über das Audiosystem ausgegebenen Audiosignals kann dabei direkt in dem Audiosystem über einen dort angeordneten Regler eingestellt werden. Die eingestellte Lautstärke wird im Folgenden auch Lautstärkeinkrement genannt.

Eine Veränderung der Fahrgeschwindigkeit führt auch zu einer Veränderung der Geräuschkulisse in dem Fahrzeug und damit zu einer veränderten Wahrnehmung des Audiosignals. Wird das Fahrzeug schneller, steigt die Geräuschkulisse und damit wird das Audiosignal schlechter wahrgenommen. Wird das Fahrzeug langsamer, sinkt dagegen die Geräuschkulisse und das Audiosignal wird damit unter Umständen zu laut.

Um also in Abhängigkeit von der Fahrgeschwindigkeit eine optimale Ausgabe des Audiosignals zu ermöglichen, weist die Vorrichtung eine Steuereinheit auf, die dazu ausgebildet ist, eine Audiosignalverstärkung basierend auf der aktuellen Lautstärke des Audiosignals und basierend auf einer aktuellen Geschwindigkeit des Kraftfahrzeugs zu bestimmen, einen ersten Lautstärkeinkrementfaktor basierend auf der eingestellten Lautstärke zu bestimmen, und die Lautstärke des Audiosignals unter Verwendung der Audiosignalverstärkung und des ersten Lautstärkeinkrementfaktors anzupassen.

Abhängig von der aktuellen Geschwindigkeit wird die Lautstärke des Audiosignals also durch einen Verstärkungswert, die Audiosignalverstärkung, angepasst (d.h. erhöht oder verringert). Zusätzlich wird die Lautstärke basierend auf der von dem Benutzer eingestellten Lautstärke mittels des ersten Lautstärkeinkrementfaktors angepasst. Das bedeutet, dass das Ausgangssignal eine Lautstärke besitzt, die von der ursprünglichen Lautstärke abhängt und basierend auf der geschwindigkeitsabhängigen Audiosignalverstärkung und der eingestellten Lautstärke angepasst ist.

Um nun das Audiosignal nicht nur in seiner Gesamtheit geschwindigkeitsabhängig anzupassen, sondern die tiefen Frequenzen getrennt davon zu berücksichtigen, ist die Steuereinheit des Weiteren dazu ausgebildet, eine Verstärkung von tiefen Frequenzen basierend auf der aktuellen Geschwindigkeit des Kraftfahrzeugs zu bestimmen, einen zweiten Lautstärkeinkrementfaktor basierend auf der eingestellten Lautstärke zu bestimmen, und die Lautstärke von tiefen Frequenzen des Audiosignals unter Verwendung der Verstärkung von tiefen Frequenzen und des zweiten Lautstärkeinkrementfaktors anzupassen.

Alternativ oder zusätzlich ist die Steuereinheit dazu ausgebildet, eine Ausgabe des Audiosignals über Körperschallwandler des Kraftfahrzeugs basierend auf einer aktuellen Geschwindigkeit des Kraftfahrzeugs unter Verwendung eines Körperschallwandlerparameters anzupassen.

Im Gegensatz zu bisherigen Systemen wird also eine Anpassung des Audiosignals unter Verwendung von verschiedenen Parametern vorgenommen: die Audiosignalverstärkung und der erste Lautstärkeinkrementfaktor werden auf das gesamte Audiosignal angewendet, die Verstärkung von tiefen Frequenzen und der zweite Lautstärkeinkrementfaktor werden auf die Ausgabe von tiefen Frequenzen über die Lautsprecher angewendet und der Körperschallwandlerparameter wird auf die Ausgabe von tiefen Frequenzen über die Körperschallwandler angewendet. Auf diese Weise können die tiefen Frequenzen, die bei höherer Geschwindigkeit aufgrund der vorhandenen Geräusche und Vibrationen untergehen können, zusätzlich zu der Anpassung des Gesamtaudiosignals noch einmal spezifisch angepasst werden. Insbesondere werden für das Audiosignal und die tiefen Frequenzen separate Lautstärkeinkrementfaktoren verwendet. Das Audiosignal kann beispielsweise vor der Anpassung nach den tiefen Frequenzen gefiltert werden (oder sein) und diese separat von dem restlichen Audiosignal angepasst werden.

Zusätzlich oder alternativ können auch die über die Körperschallwandler ausgegebenen Signale angepasst werden. Da für die verschiedenen Anpassungen verschiedene Parameter verwendet werden, ist es möglich, auf die verschiedenen Elemente, die das Audiosignal ausgegeben können, individuell einzugehen und die jeweils optimale Anpassung vorzunehmen.

Gemäß einer Ausführungsform ist die Steuereinheit dazu ausgebildet, die Ausgabe des Audiosignals über Körperschallwandler basierend auf dem ersten Lautstärkeinkrementfaktor anzupassen. Bei der Ausgabe des Audiosignals über die Körperschallwandler kann die Steuereinheit somit eine Anpassung sowohl auf dem ersten Lautstärkeinkrementfaktor als auch dem Körperschallwandlerparameter vornehmen. Die Steuereinheit kann somit hier auch die Anpassung der Lautstärke des Audiosignals berücksichtigen, d.h. wenn das Audiosignal lauter gestellt wird, die Ausgabe über die Körperschallwandler ebenfalls erhöhen, und wenn das Audiosignal leiser gestellt wird, die Ausgabe über die Körperschallwandler verringern.

Gemäß einer weiteren Ausführungsform weist die Vorrichtung eine Speichereinheit auf, in der mehrere erste Lautstärkeinkrementfaktoren mit zugeordneten eingestellten Lautstärken, mehrere zweite Lautstärkeinkrementfaktoren mit zugeordneten eingestellten Lautstärken, mehrere Körperschallwandlerparameter mit zugeordneten Geschwindigkeiten, mehrere Audiosignalverstärkungen mit zugeordneten Geschwindigkeiten und/oder mehrere Verstärkungen von tiefen Frequenzen mit zugeordneten Geschwindigkeiten gespeichert sind. Die entsprechenden Faktoren bzw. Parameter können insbesondere in Tabellen gespeichert sein, wobei die jeweilige Tabelle basierend auf dem jeweils einzustellenden Parameter ausgewählt wird. Durch die Verwendung solcher Tabellen ist eine schnelle und einfache Anpassung der Werte ohne großen Rechenaufwand möglich.

Rein beispielhaft sind hier vier Tabellen dargestellt, gemäß denen die Anpassung der jeweiligen Verstärkung (Audiosignalverstärkung und Verstärkung von tiefen Frequenzen), des Lautstärkeinkrementfaktors (beispielhaft ist hier der erste Lautstärkeinkrementfaktor gezeigt) und des Körperschallwandlerparameters erfolgen kann. Andere Werte sind hier ebenfalls möglich und nicht ausgeschlossen. In diesem Beispiel erfolgt die Anpassung des gesamten Audiosignals und der Körperschallwandler unter Verwendung derselben Werte. Es sollte jedoch beachtet werden, dass hier auch unterschiedliche Werte verwendet werden können.

**Tabelle 1: Anpassung der Audiosignalverstärkung**

| Geschwindigkeit | Audiosignalverstärkung |
|---|---|
| 0 km/h | 0 dB |
| 10 km/h | 0,5 dB |
| 20 km/h | 1 dB |
| 30 km/h | 1,5 dB |
| 40 km/h | 2 dB |
| 50 km/h | 2,5 dB |
| 60 km/h | 3 dB |
| ... | ... |

**Tabelle 2: Anpassung der Verstärkung von tiefen Frequenzen**

| Geschwindigkeit | Verstärkung von tiefen Frequenzen |
|---|---|
| 0 km/h | 0,1 dB |
| 10 km/h | 0,2 dB |
| 20 km/h | 0,3 dB |
| 30 km/h | 0,4 dB |
| 40 km/h | 0,5 dB |
| 50 km/h | 0,6 dB |
| 60 km/h | 0,7 dB |
| ... | ... |

**Tabelle 3: Anpassung des ersten Lautstärkeinkrementfaktors**

| Lautstärkeinkrement | Erster Lautstärkeinkrementfaktor |
|---|---|
| 0 | 0 |
| 5 | 0,2 |
| 10 | 0,4 |
| 15 | 0,6 |
| 20 | 0,8 |
| 25 | 1,0 |
| 30 | 1,2 |
| 35 | 1,4 |
| ... | ... |

**Tabelle 4: Anpassung des Körperschallwandlerparameters**

| Geschwindigkeit | Körperschallwandlerparameter |
|---|---|
| 0 km/h | 0 dB |
| 10 km/h | 0,5 dB |
| 20 km/h | 1 dB |
| 30 km/h | 1,5 dB |
| 40 km/h | 2 dB |
| 50 km/h | 2,5 dB |
| 60 km/h | 3 dB |
| ... | ... |

Wie bereits erwähnt, ist hier lediglich beispielhaft eine Tabelle für den ersten Lautstärkeinkrementfaktor gezeigt. Eine ähnliche Tabelle kann für den zweiten Lautstärkeinkrementfaktor verwendet werden, wobei die Werte für den ersten und den zweiten Lautstärkeinkrementfaktor vorzugsweise unterschiedlich sind, um die speziellen Anforderungen des gesamten Audiosignals und der tiefen Frequenzen zu berücksichtigen, wie oben erläutert ist.

Grundsätzlich werden für die Anpassung der Lautstärke basierend auf der Regelung durch einen Benutzer Lautstärkeinkrementfaktoren verwendet werden. Hierbei wird ein Lautstärkeinkrement, das der Regelung durch den Benutzer auf einer Einstelleinheit, z.B. einem Lautstärkeregler, entspricht, in einen (ersten oder zweiten) Lautstärkeinkrementfaktor umgesetzt, der auf die Lautstärke des Audiosignals angewandt wird, um dessen Lautstärke am Ausgang des Audiosystems zu erhöhen.

Wie bereits oben erwähnt, können die Werte für die jeweiligen Parameter basierend auf diesen Tabellen ausgewählt werden. Dies hat den Vorteil, dass keine Berechnung der Werte erforderlich ist, sondern diese einfach aus der Speichereinheit ausgelesen werden können. Des Weiteren können auf diese Weise einfach und ohne großen Rechenaufwand für jeden Parameter andere Werte ausgelesen werden.

Gemäß einer weiteren Ausführungsform ist die Steuereinheit dazu ausgebildet, basierend auf der aktuellen Geschwindigkeit und der eingestellten Lautstärke, d.h. dem Lautstärkeinkrement, Frequenzen auszuwählen, die unter Verwendung der Verstärkung von tiefen Frequenzen und des zweiten Lautstärkeinkrementfaktors angepasst werden. Da bei unterschiedlichen Geschwindigkeiten unterschiedliche Frequenzen besser oder schlechter zu hören sind, kann die Steuereinheit gemäß dieser Ausführungsform diejenigen Frequenzen auswählen, die anzupassen sind. Dies kann unter Verwendung eines Filters, insbesondere eines Tiefpass- oder Bassfilters, erfolgen, der bestimmte Frequenzen aus dem Audiosignal herausfiltert, um diese anzupassen. Zusätzlich kann hier auch eine Anpassung der Filtergüte, d.h. der Flankensteilheit, basierend auf der aktuellen Geschwindigkeit und dem eingestellten Lautstärkeinkrement erfolgen.

Zur Anpassung des Filters können ebenfalls Tabellen verwendet werden. Im Folgenden sind beispielhaft zwei Tabellen dargestellt, die zum einen eine Frequenz des Filters für beispielhafte Geschwindigkeiten und Lautstärkeinkremente (Tabelle 5) und eine Filtergüte des Filters für beispielhafte Geschwindigkeiten und Lautstärkeinkremente (Tabelle 6) darstellen. Wie zu sehen ist, wird die Anpassung mit Erhöhung der Geschwindigkeit auf niedrigere Frequenzen (d.h. alle Frequenzen unterhalb der jeweiligen Filterfrequenz) angewendet, da diese mit höherer Geschwindigkeit und damit höherer Geräuschkulisse verstärkt werden sollten, um noch wahrgenommen zu werden.

**Tabelle 5: Geschwindigkeits- und lautstärkeinkrementabhängige Frequenz des Filters**

| Geschwindigkeit | Lautstärkeinkrement | Filterfrequenz |
|---|---|---|
| 0 km/h | 0 | 0 Hz |
| | 20 | 160 Hz |
| | 40 | 155 Hz |
| | 60 | 150 Hz |
| 10 km/h | 0 | 145 Hz |
| | 20 | 140 Hz |
| | 40 | 135 Hz |
| | 60 | 130 Hz |
| 20 km/h | 0 | 125 Hz |
| | 20 | 120 Hz |
| | 40 | 115 Hz |
| | 60 | 110 Hz |
| 30 km/h | 0 | 105 Hz |
| | 20 | 100 Hz |
| | 40 | 95 Hz |
| | 60 | 90 Hz |
| ... | ... | |

**Tabelle 6: Geschwindigkeits- und lautstärkeinkrementabhängige Güte des Filters**

| Geschwindigkeit | Lautstärkeinkrement | Filtergüte |
|---|---|---|
| 0 km/h | 0 | 0,1 |
| | 10 | 0,2 |
| | 20 | 0,3 |
| | 30 | 0,4 |
| 10 km/h | 0 | 0,6 |
| | 10 | 0,7 |
| | 20 | 0,8 |
| | 30 | 0,9 |
| 20 km/h | 0 | 0,6 |
| | 10 | 0,7 |
| | 20 | 0,8 |
| | 30 | 0,9 |
| 30 km/h | 0 | 1,6 |
| | 10 | 1,7 |
| | 20 | 1,8 |
| | 30 | 1,9 |
| | 40 | 2,0 |
| ... | ... | |

Gemäß einer weiteren Ausführungsform weist die Vorrichtung eine Einstelleinheit auf, die dazu ausgebildet ist, eine Benutzereingabe zu empfangen, um die Berücksichtigung der Geschwindigkeit bei der Anpassung der Lautstärke des Audiosignals, der Lautstärke der tiefen Frequenzen und/oder der Ausgabe des Audiosignals über Körperschallwandler zu erhöhen oder zu verringern. Der Benutzer kann hierdurch individuell einstellen, wie ausgeprägt die geschwindigkeitsabhängige Anhebung (oder Absenkung) sein soll. Die Einstelleinheit kann beispielsweise als Slider-Element in einer Benutzeroberfläche des Fahrzeugs vorgesehen sein. Die Einstellung kann dabei vorzugsweise jeweils für das gesamte Audiosignal, die tiefen Frequenzen und die Körperschallwandler separat vorgenommen werden.

Wie für die geschwindigkeitsabhängige Anpassung und die Einstellung der Lautstärke durch einen Benutzer kann auch hier eine Tabelle verwendet werden, aus der auf einfache Weise die entsprechenden Werte ausgelesen und in das Audiosystem übertragen werden können. Die Faktoren zur Anpassung des Audiosignals in seiner Gesamtheit und der tiefen Frequenzen sind in diesem Beispiel dieselben, können aber auch unterschiedlich sein. Des Weiteren können die Faktoren der Körperschallwandler, obwohl hier als unterschiedlich aufgeführt, auch dieselben wie die des Audiosignals und/oder der tiefen Frequenzen sein. Auch sind hier beispielhaft fünf Stufen vorhanden, es können aber auch mehr oder weniger Stufen der Einstellung vorhanden sein.

**Tabelle 7: Einstellung der geschwindigkeitsabhängigen Anpassung**

| Stufe | Faktor Audiosignal/tiefe Frequenzen | Faktor Körperschallwandler |
|---|---|---|
| 1 | 0 | 0 |
| 2 | 0,5 | 0,1 |
| 3 | 1 | 0,2 |
| 4 | 1,5 | 0,3 |
| 5 | 2 | 0,4 |

Basierend auf der Auswahl der Stufe können auch unterschiedliche Tabellen für die Auswahl der Audiosignalverstärkung, der Verstärkung der tiefen Frequenzen, des ersten Lautstärkeinkrementfaktors, des zweiten Lautstärkeinkrementfaktors und/oder des Körperschallwandlerparameters ausgewählt werden. Dies vereinfacht weiter die Anpassung des Audiosignals, da keine Berechnungen erforderlich sind, sondern einfach nur verschiedene Tabellen mit verschiedenen Werten basierend auf der Stufe der geschwindigkeitsabhängigen Anpassung ausgewählt werden können.

Gemäß einer weiteren Ausführungsform ist die Steuereinheit dazu ausgebildet, die Eingangsquelle zu bestimmen und basierend auf der bestimmten Eingangsquelle die Lautstärke des Audiosignals, die Lautstärke der tiefen Frequenzen und/oder die Ausgabe des Audiosignals über Körperschallwandler anzupassen. Beispielsweise kann bei einer Ausgabe von einem Navigationsgerät eine Anpassung der tiefen Frequenzen und/oder der Körperschallwandler entfallen. Die Steuereinheit kann dabei auch einen Wechsel zwischen Eingangsquellen erkennen und eine entsprechende Anpassung vornehmen.

Gemäß einer weiteren Ausführungsform ist die Steuereinheit dazu ausgebildet ist, zu bestimmen, ob ein Dach und/oder Fenster des Kraftfahrzeugs geöffnet ist, und wenn ja, die Lautstärke des Audiosignals, die Lautstärke der tiefen Frequenzen und/oder die Ausgabe des Audiosignals über Körperschallwandler um einen vorbestimmten Wert zu erhöhen. Ein geöffnetes Dach (Cabrio-Dach oder Schiebedach) und/oder geöffnete Fenster können die Geräuschkulisse im Fahrzeug und damit die Wahrnehmung des Audiosignals beeinflussen. Daher kann die Steuereinheit alle oder einen Teil der oben aufgelisteten Faktoren bzw. Parameter entsprechend anpassen, um diese Geräuschkulisse auszugleichen. Insbesondere können tiefe Frequenzen und/oder die Ausgabe über Körperschallwandler weiter erhöht werden, da diese sonst womöglich nicht wahrgenommen werden.

Gemäß einem weiteren Aspekt wird ein Kraftfahrzeug mit einer wie oben beschriebenen Vorrichtung zum Anpassen der Lautstärke eines Audiosignals vorgeschlagen.

Gemäß einem weiteren Aspekt wird ein Verfahren zum Anpassen der Lautstärke eines Audiosignals in einem Audiosystem eines Kraftfahrzeugs vorgeschlagen, wobei das Audiosystem das Audiosignal von einer Eingangsquelle, beispielsweise einer Entertainmentquelle, an einem Eingang empfängt und an einem Ausgang ausgibt, wobei die Lautstärke des Audiosignals mittels eines Reglers des Audiosystems einstellbar ist, wobei das Verfahren ein Bestimmen einer Audiosignalverstärkung basierend auf der aktuellen Lautstärke des Audiosignals und basierend auf einer aktuellen Geschwindigkeit des Kraftfahrzeugs, ein Bestimmen eines ersten Lautstärkeinkrementfaktors basierend auf der eingestellten Lautstärke, und ein Anpassen der Lautstärke des Audiosignals unter Verwendung der Audiosignalverstärkung und des ersten Lautstärkeinkrementfaktors aufweist. Das Verfahren weist des Weiteren ein Bestimmen einer Verstärkung von tiefen Frequenzen basierend auf der aktuellen Geschwindigkeit des Kraftfahrzeugs, ein Bestimmen eines zweiten Lautstärkeinkrementfaktors basierend auf der eingestellten Lautstärke, und ein Anpassen der Lautstärke von tiefen Frequenzen des Audiosignals unter Verwendung der Verstärkung von tiefen Frequenzen und des zweiten Lautstärkeinkrementfaktors auf.

Alternativ oder zusätzlich weist das Verfahren ein Anpassen einer Ausgabe des Audiosignals über Körperschallwandler des Kraftfahrzeugs basierend auf der aktuellen Geschwindigkeit des Kraftfahrzeugs unter Verwendung eines Körperschallwandlerparameters auf.

Die für die vorgeschlagene Vorrichtung beschriebenen Ausführungsformen und Merkmale gelten für das vorgeschlagene Verfahren entsprechend.

Weiterhin wird ein Computerprogrammprodukt vorgeschlagen, welches einen Programmcode aufweist, der dazu ausgebildet ist, auf einem Computer die Durchführung des wie oben erläuterten Verfahrens zu veranlassen.

Ein Computerprogrammprodukt, wie z.B. ein Computerprogramm-Mittel, kann beispielsweise als Speichermedium, wie z.B. Speicherkarte, USB-Stick, CD-ROM, DVD, oder auch in Form einer herunterladbaren Datei von einem Server in einem Netzwerk bereitgestellt oder geliefert werden. Dies kann z.B. in einem drahtlosen Kommunikationsnetzwerk durch die Übertragung einer entsprechenden Datei mit dem Computerprogrammprodukt oder dem Computerprogramm-Mittel erfolgen.

Weitere mögliche Implementierungen der Erfindung umfassen auch nicht explizit genannte Kombinationen von zuvor oder im Folgenden bezüglich der Ausführungsbeispiele beschriebenen Merkmale oder Ausführungsformen. Dabei wird der Fachmann auch Einzelaspekte als Verbesserungen oder Ergänzungen zu der jeweiligen Grundform der Erfindung hinzufügen.

Weitere Vorteile und vorteilhafte Ausführungsformen sind in der Beschreibung, den Zeichnungen und den Ansprüchen angegeben. Dabei sind insbesondere die in der Beschreibung und in den Zeichnungen angegebenen Kombinationen der Merkmale rein exemplarisch, so dass die Merkmale auch einzeln oder anders kombiniert vorliegen können.

Im Folgenden soll die Erfindung anhand von in den Zeichnungen dargestellten Ausführungsbeispielen näher beschrieben werden. Dabei sind die Ausführungsbeispiele und die in den Ausführungsbeispielen gezeigten Kombinationen rein exemplarisch und sollen nicht den Schutzbereich der Erfindung festlegen. Dieser wird allein durch die anhängigen Ansprüche definiert.

Es zeigen:
Fig. 1: ein schematisches Blockdiagramm einer Vorrichtung zum Anpassen der Lautstärke eines Audiosignals in einem Audiosystem eines Kraftfahrzeugs;
Fig. 2: einen Beispielalgorithmus zum Anpassen von tiefen Frequenzen durch die Vorrichtung von Fig. 1; und
Fig. 3: einen Beispielalgorithmus zum Anpassen von Ausgaben durch Körperschallwandler durch die Vorrichtung von Fig. 1.

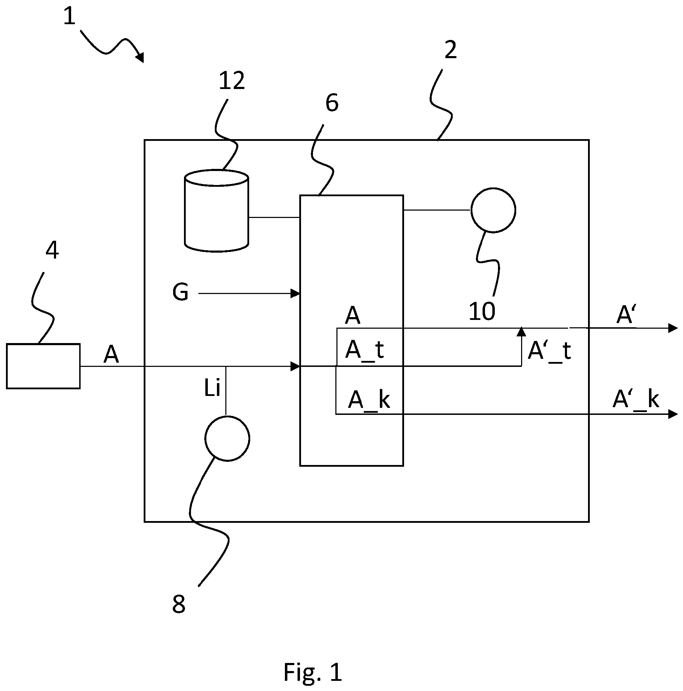

Fig. 1 zeigt eine Vorrichtung 1 zum Anpassen der Lautstärke eines Audiosignals A in einem Audiosystem 2 eines Kraftfahrzeugs.

Das Audiosystem 2 kann das Audiosignal A über einen Eingang von einer Eingangsquelle 4 empfangen. Die Eingangsquelle 4 kann eine beliebige Audiosignalquelle, wie eine Entertainmentquelle, z.B. Radio, sein.

Die Vorrichtung 1 weist eine Steuereinheit 6 auf, die dazu ausgebildet ist, das Audiosignal A bezüglich seiner Lautstärke am Ausgang des Audiosystems 2 anzupassen. Hierbei kann die Steuereinheit 6 zum einen das Audiosignal A basierend auf einem Lautstärkeregler 8 anpassen. Der Lautstärkeregler 8 gibt ein Lautstärkeinkrement Li an, welches definiert, um welches Inkrement die Lautstärke des Eingangsaudiosignals A erhöht oder verringert werden soll. Zusätzlich kann die Steuereinheit 6 eine geschwindigkeitsbasierte Anpassung vornehmen. Hierzu bestimmt die Steuereinheit 6 die aktuelle Geschwindigkeit G des Fahrzeugs. Da bei einer höheren Geschwindigkeit die Geräuschkulisse höher ist, wird durch die Steuereinheit 6 entsprechend auch die Lautstärke erhöht, so dass die Fahrzeuginsassen auch bei höheren Geschwindigkeiten noch in der Lage sind, das ausgegebene Audiosignal zu hören.

Um nun, im Vergleich zu bisherigen Systemen, eine optimierte Anpassung des Audiosignals A zu erreichen, ist die Steuereinheit 6 nicht nur dazu geeignet, das Audiosignal A basierend auf der eingestellten Lautstärke und der aktuellen Geschwindigkeit G anzupassen, sondern kann auch eine individuelle Anpassung der tieferen Frequenzen und/oder eine Anpassung der Ausgabe über Körperschallwandler basierend auf der aktuellen Geschwindigkeit G und dem Lautstärkeinkrement Li vornehmen.

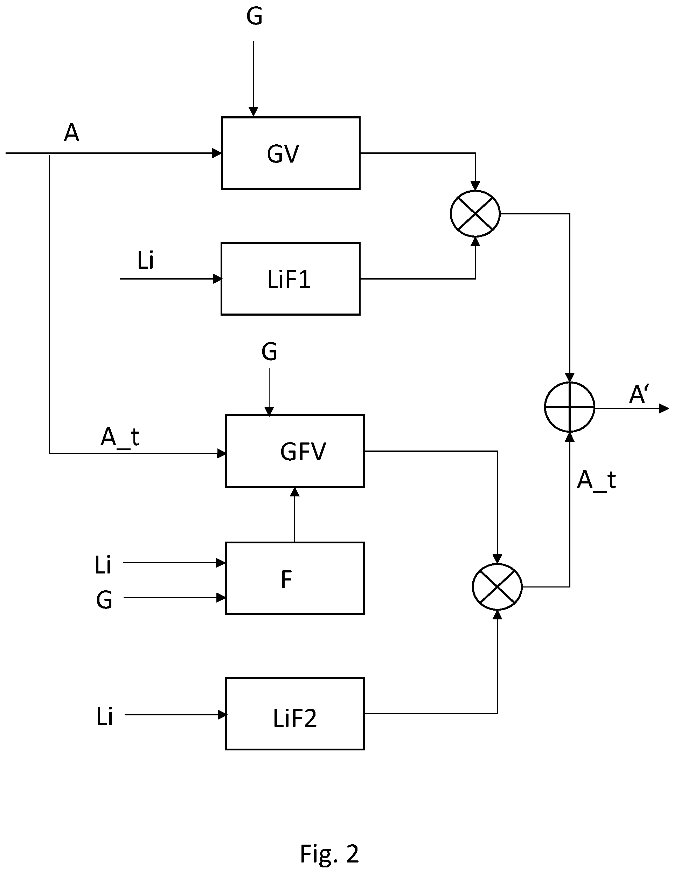

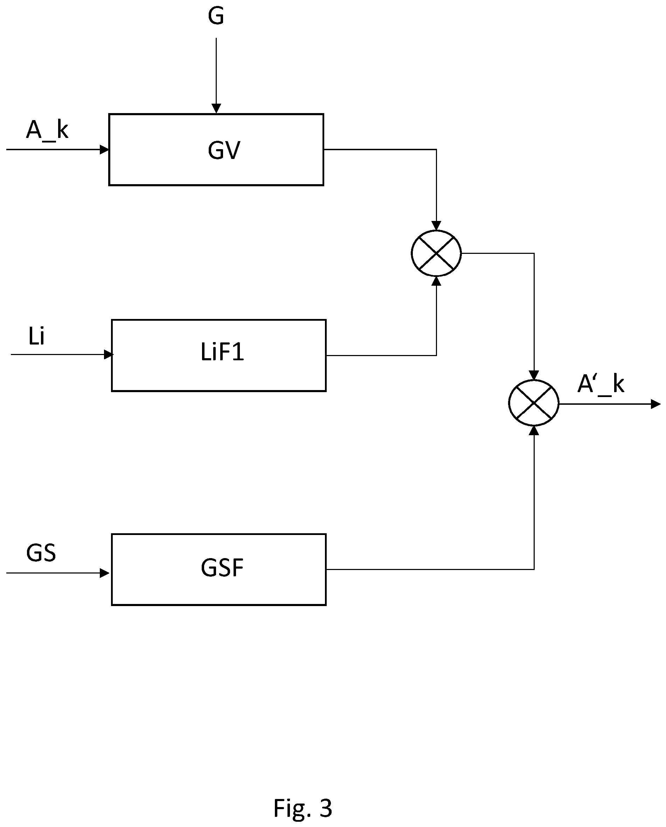

Hierzu verarbeitet die Steuereinheit 6 zum einen das gesamte Audiosignal A, wie oben beschrieben, und zum anderen zusätzlich die tiefen Frequenzen A_t sowie das Audiosignal A_k für die Körperschallwandler. Insbesondere kann die Steuereinheit 6 basierend auf der aktuellen Geschwindigkeit G und dem Lautstärkeinkrement Li entsprechende Faktoren und Parameter für die Verarbeitung der jeweiligen Signale aus einer Speichereinheit oder Datenbank 12 abrufen, wie unten mit Bezug auf Figuren 2 und 3 näher beschrieben wird.

Des Weiteren kann die Vorrichtung 1 eine Einstelleinheit 10 aufweisen. Über diese kann ein Benutzer einstellen, wie stark die geschwindigkeitsabhängige Anpassung des Audiosignals A erfolgen soll. Dies kann durch die Steuereinheit 6 bei der Verarbeitung ebenfalls berücksichtigt werden.

Nach der Anpassung der jeweiligen Signale kann die Steuereinheit 6 dann ein angepasstes Audiosignal A', das auch die angepassten tiefen Frequenzen A'_t enthält, und ein angepasstes Signal A'_k für die Körperschallwandler ausgeben.

Im Folgenden wird nun unter Bezugnahme auf Fig. 2 die Anpassung der tiefen Frequenzen im Detail beschrieben.

Wie bereits oben beschrieben wird das Audiosignal A zum einen in seiner Gesamtheit angepasst. Abhängig von der aktuellen Geschwindigkeit G wird ein Verstärkungsfaktor GV (Audiosignalverstärkungsfaktor) bestimmt. Dieser Verstärkungsfaktor GV bestimmt, um welchen Wert das Audiosignal A verstärkt werden soll, um eine höhere Geschwindigkeit auszugleichen. Zusätzlich wird ein erster Lautstärkeinkrementfaktor LiF1 bestimmt, der von der eingestellten Lautstärke bzw. dem zugehörigen Lautstärkeinkrement Li abhängt. Diese Werte können in der oben beschriebenen Datenbank 12 hinterlegt sein und unter Verwendung der oben gezeigten Tabellen abgerufen werden.

Die Erhöhung der Lautstärke des Audiosignals wird als Verstärkung (Gain_Signal) des Audiosignals umgesetzt und kann in dieser ersten Anpassungsstufe somit als Gain_Signal = Audiosignalverstärkungsfaktor * erster Lautstärkeinkrementfaktor dargestellt werden.

Zusätzlich werden die tiefen Frequenzen A_t des Audiosignals in einer zweiten Anpassungsstufe angepasst. Hier werden zum einen mittels eines Bassfilters GFV mit einer bestimmten Verstärkung von tiefen Frequenzen (Bassfilterverstärkungsfaktor) die tiefen Frequenzen A_t des Audio Signals A geschwindigkeitsabhängig angehoben und mit einem zweiten Lautstärkeinkrementfaktor LiF2 multipliziert. Der zweite Lautstärkeinkrementfaktor LiF2 wird dabei, unabhängig von dem ersten Lautstärkeinkrementfaktor LiF2, basierend auf dem aktuellen Lautstärkeinkrement ausgewählt. Für die tiefen Frequenzen, d.h. die Frequenzen, die unterhalb der Filterfrequenz des Bassfilters GFV liegen, gilt daher analog zum Audiosignal A: Gain_Signal = Bassfilterverstärkungsfaktor * zweiter Lautstärkeinkrementfaktor.

Zusätzlich kann der Bassfilter GFV in seinen Eigenschaften, d.h. der genauen Filterfrequenz und der Güte des Filters, angepasst werden. Diese Filtereigenschaften können basierend auf dem Lautstärkeinkrement Li sowie der aktuellen Geschwindigkeit G ausgewählt werden. Die Filtereigenschaften können ebenfalls in der Datenbank 12 abgelegt und von dieser abgerufen werden.

Anschließend werden die Ausgänge der beiden Anpassungsstufen zusammengeführt und das angepasste Audiosignal A' wird ausgegeben.

Um die Einstellung der Einstelleinheit zu berücksichtigen, d.h. zu berücksichtigen, in welchem Umfang eine Anpassung stattfinden soll, können die jeweiligen Signale zusätzlich mit einem weiteren Faktor multipliziert werden. Alternativ kann die Steuereinheit 6 auf verschiedene Tabellen zugreifen, die in der Datenbank 12 gespeichert sind und mit unterschiedlichen Werten für jede Einstellstufe befüllt sind.

Wie die Anpassung der tiefen Frequenzen A_t kann auch eine Anpassung des Eingangssignals A_k für Körperschallwandler oder Shaker erfolgen, wie im Folgenden unter Bezug auf Fig. 3 beschrieben ist. Das Eingangssignal A_k für die Körperschallwandler basiert auf dem Audiosignal A und dient dazu, die Körperschallwandler anzuregen.

Wie bereits oben unter Bezug auf Fig. 2 beschrieben, wird auch hier eine Audiosignalverstärkung GV des Signals A_k basierend auf der aktuellen Geschwindigkeit G sowie dem Lautstärkeinkrement Li ermittelt, um die Intensität der Körperschallwandler in Abhängigkeit zur Geschwindigkeit anzuheben. Auf diese Weise sind die Körperschallwandler bei allen Fahrgeschwindigkeiten und Lautstärken gut spürbar.

Die Erhöhung der Intensität wird als Anhebung der Verstärkung des Eingangssignals A_k umgesetzt und kann wie folgt dargestellt werden: (Shaker-) Signal_Gain = Audiosignalverstärkungsfaktor * erster Lautstärkeinkrementfaktor. Wie die übrigen Werte sind auch diese Werte in der Datenbank 12 gespeichert. Statt des ersten Lautstärkeinkrementfaktors kann auch der zweite Lautstärkeinkrementfaktor oder ein dritter, von dem ersten und dem zweiten Lautstärkeinkrementfaktor unabhängiger Faktor verwendet werden. In diesem letzten Fall kann eine entsprechende Tabelle in der Datenbank 12 gespeichert sein.

Optional kann auch eine Benutzereinstellung GS erfolgen, um zu bestimmen, wie umfangsreich die geschwindigkeitsabhängige Anhebung sein soll. Dies kann ebenfalls für die Ausführungsform der Fig. 2 angewendet werden.

Basierend auf der Benutzereinstellung GS wird ein Faktor GSF bestimmt, mit dem das lautstärkeninkrement- und geschwindigkeitsangepasste Signal multipliziert werden kann, um das angepasste Signal A'_k für die Körperschallwandler zu erhalten.

Es sollte beachtet werden, dass die Ausführungsformen der Figuren 2 und 3 auch kombiniert werden können oder dass die Anpassung der tiefen Frequenzen in Fig. 2 durch die Anpassung der Signale für Körperschallwandler aus Fig. 3 ersetzt werden kann.

Durch die hier beschriebene Vorrichtung ist eine umfassende Anpassung der Audiosignale in einem Fahrzeug basierend auf der aktuellen Geschwindigkeit möglich.

### Bezugszeichen

- 1: Vorrichtung
- 2: Audiosystem
- 4: Eingangsquelle
- 6: Steuereinheit
- 8: Lautstärkeregler
- 10: Einstelleinheit
- 12: Speichereinheit
- A: Audiosignal
- A': angepasstes Audiosignal
- A_t: tiefe Frequenzen
- A_t': angepasste tiefe Frequenzen
- A_k: Audiosignal für Körperschallwandler
- A_k': angepasstes Audiosignal für Körperschallwandler
- F: Filtereigenschaften
- G: Geschwindigkeit
- GFV: Geschwindigkeitsabhängige Verstärkung des Filters
- GS: Geschwindigkeitseinstellungsstufe
- GSF: Faktor für Geschwindigkeitseinstellungsstufe
- GV: Geschwindigkeitsabhängige Verstärkung
- Li: Lautstärkeinkrement
- LiF1: erster Lautstärkeinkrementfaktor
- LiF2: zweiter Lautstärkeinkrementfaktor

## Patentansprüche

1. Vorrichtung (1) zum Anpassen der Lautstärke eines Audiosignals (A) in einem Audiosystem (2) eines Kraftfahrzeugs, wobei das Audiosystem (2) einen Eingang zum Empfangen des Audiosignals (A) von einer Eingangsquelle (4) und einen Ausgang zum Ausgeben des Audiosignals (A') aufweist, wobei die Lautstärke des Audiosignals (A) mittels eines Reglers (8) des Audiosystems (2) einstellbar ist, wobei die Vorrichtung (1) eine Steuereinheit (6) aufweist, die dazu ausgebildet ist, eine Audiosignalverstärkung (GV) basierend auf der aktuellen Lautstärke des Audiosignals (A) und basierend auf einer aktuellen Geschwindigkeit (G) des Kraftfahrzeugs zu bestimmen, einen ersten Lautstärkeinkrementfaktor (LiF1) basierend auf der eingestellten Lautstärke (Li) zu bestimmen, und die Lautstärke des Audiosignals (A) unter Verwendung der Audiosignalverstärkung (GV) und des ersten Lautstärkeinkrementfaktors (LiF1) anzupassen,
**dadurch gekennzeichnet, dass** die Steuereinheit (6) des Weiteren dazu ausgebildet ist, eine Verstärkung (GFV) von tiefen Frequenzen basierend auf der aktuellen Geschwindigkeit (G) des Kraftfahrzeugs zu bestimmen, einen zweiten Lautstärkeinkrementfaktor (LiF2) basierend auf der eingestellten Lautstärke (Li) zu bestimmen, und die Lautstärke von tiefen Frequenzen des Audiosignals (A) unter Verwendung der Verstärkung (GFV) von tiefen Frequenzen und des zweiten Lautstärkeinkrementfaktors (LiF2) anzupassen, und/oder
dass die Steuereinheit (6) dazu ausgebildet ist, eine Ausgabe des Audiosignals (A_k) über Körperschallwandler des Kraftfahrzeugs basierend auf der aktuellen Geschwindigkeit (G) des Kraftfahrzeugs unter Verwendung eines Körperschallwandlerparameters (GV) anzupassen.

2. Vorrichtung nach Anspruch 1, **dadurch gekennzeichnet, dass** die Steuereinheit (6) dazu ausgebildet ist, die Ausgabe des Audiosignals (A_k) über Körperschallwandler basierend auf dem ersten Lautstärkeinkrementfaktor (LiF1) anzupassen.

3. Vorrichtung nach einem der vorhergehenden Ansprüche, **dadurch gekennzeichnet, dass** die Steuereinheit (6) dazu ausgebildet ist, basierend auf der aktuellen Geschwindigkeit (G) und der eingestellten Lautstärke (Li) Frequenzen auszuwählen, die unter Verwendung der Verstärkung (GFV) von tiefen Frequenzen angepasst werden.

4. Vorrichtung nach einem der vorhergehenden Ansprüche, **dadurch gekennzeichnet, dass** die Vorrichtung (1) eine Speichereinheit aufweist, in der mehrere erste Lautstärkeinkrementfaktoren (LiF1) mit zugeordneten eingestellten Lautstärken (Li), mehrere zweite Lautstärkeinkrementfaktoren (LiF2) mit zugeordneten eingestellten Lautstärken (Li), mehrere Körperschallwandlerparameter (GV) mit zugeordneten Geschwindigkeiten (G), mehrere Audiosignalverstärkungen (GV) mit zugeordneten Geschwindigkeiten (G) und/oder mehrere Verstärkungen (GFV) von tiefen Frequenzen mit zugeordneten Geschwindigkeiten (G) gespeichert sind.

5. Vorrichtung nach einem der vorhergehenden Ansprüche, **dadurch gekennzeichnet, dass** die Vorrichtung (1) eine Einstelleinheit aufweist, die dazu ausgebildet ist, eine Benutzereingabe zu empfangen, um die Berücksichtigung der Geschwindigkeit (G) bei der Anpassung der Lautstärke des Audiosignals (A), der Lautstärke der tiefen Frequenzen und/oder der Ausgabe des Audiosignals (A_k) über Körperschallwandler zu erhöhen oder zu verringern.

6. Vorrichtung nach einem der vorhergehenden Ansprüche, **dadurch gekennzeichnet, dass** die Steuereinheit (6) dazu ausgebildet ist, die Eingangsquelle zu bestimmen und basierend auf der bestimmten Eingangsquelle die Lautstärke des Audiosignals (A), die Lautstärke der tiefen Frequenzen und/oder die Ausgabe des Audiosignals (A_k) über Körperschallwandler anzupassen.

7. Vorrichtung nach einem der vorhergehenden Ansprüche, **dadurch gekennzeichnet, dass** die Steuereinheit (6) dazu ausgebildet ist, zu bestimmen, ob ein Dach und/oder Fenster des Kraftfahrzeugs geöffnet ist, und wenn ja, die Lautstärke des Audiosignals (A), die Lautstärke der tiefen Frequenzen und/oder die Ausgabe des Audiosignals (A_k) über Körperschallwandler um einen vorbestimmten Wert zu erhöhen.

8. Kraftfahrzeug mit einer Vorrichtung (1) zum Anpassen der Lautstärke eines Audiosignals (A) gemäß einem der vorhergehenden Ansprüche.

9. Verfahren zum Anpassen der Lautstärke eines Audiosignals (A) in einem Audiosystem (2) eines Kraftfahrzeugs, wobei das Audiosystem (2) das Audiosignal (A) von einer Eingangsquelle (4) an einem Eingang empfängt und an einem Ausgang ausgibt, wobei die Lautstärke des Audiosignals (A) mittels eines Reglers (8) des Audiosystems (2) einstellbar ist, wobei das Verfahren ein Bestimmen einer Audiosignalverstärkung (GV) basierend auf der aktuellen Lautstärke des Audiosignals (A) und basierend auf einer aktuellen Geschwindigkeit (G) des Kraftfahrzeugs, ein Bestimmen eines ersten Lautstärkeinkrementfaktors (LiF1) basierend auf der eingestellten Lautstärke (Li), und ein Anpassen der Lautstärke des Audiosignals (A) unter Verwendung der Audiosignalverstärkung (GV) und des ersten Lautstärkeinkrementfaktors (LiF1) aufweist,
**dadurch gekennzeichnet, dass** das Verfahren des Weiteren ein Bestimmen einer Verstärkung (GFV) von tiefen Frequenzen basierend auf der aktuellen Geschwindigkeit (G) des Kraftfahrzeugs, ein Bestimmen eines zweiten Lautstärkeinkrementfaktors (LiF2) basierend auf der eingestellten Lautstärke (Li), und ein Anpassen der Lautstärke von tiefen Frequenzen des Audiosignals (A) unter Verwendung der Verstärkung (GFV) von tiefen Frequenzen und des zweiten Lautstärkeinkrementfaktors (LiF2) aufweist, und/oder
dass das Verfahren ein Anpassen einer Ausgabe des Audiosignals (A_k) über Körperschallwandler des Kraftfahrzeugs basierend auf der aktuellen Geschwindigkeit (G) des Kraftfahrzeugs unter Verwendung eines Körperschallwandlerparameters (GV) aufweist.
